# EUROPEAN PATENT SPECIFICATION

(11) **EP 0 903 752 B1**
(45) Date of publication and mention of the grant of the patent: **14.11.2001**
(21) Application number: 98121757.3
(22) Date of filing: 29.12.1992
(51) Int. Cl.: G11C 29/00, G11C 16/06, G11C 7/06

(54) **Nonvolatile semiconductor memory**
Nicht-flüchtige Halbleiter-Speicher-Vorrichtung
Dispositif de mémoire à semiconducteur non volatile

(30) Priority: 20.07.1992 JP 19179392; 27.12.1991 JP 34666391
(43) Date of publication of application: 24.03.1999
(62) Divisional of application: 92311829.3
(73) Proprietor: FUJITSU LIMITED, Kawasaki-shi, Kanagawa 211-8588 (JP)
(72) Inventor: Ogawa, Yasushige, c/o Fujitsu VLSI Ltd., Kasugai-shi, Aichi 487 (JP); Akaogi, Takao,, Kawasaki-shi,Kanagawa 211-8588, (JP)
(74) Representative: Hitching, Peter Matthew

(56) References cited:
- EP-A- 0 443 776
- EP-A- 0 496 523
- US-A- 4 823 031

## Description

This invention relates to a nonvolatile semiconductor memory, particularly to an EPROM and an EEPROM including a nonvolatile memory circuit and, more particularly to a circuit construction of a nonvolatile semiconductor memory of the batch erasure type (hereinafter referred to as a flash memory).

The invention further relates particularly to a circuit construction concerning a sense amplifying (S/A) circuit and a high speed reading operation in a nonvolatile semiconductor memory.

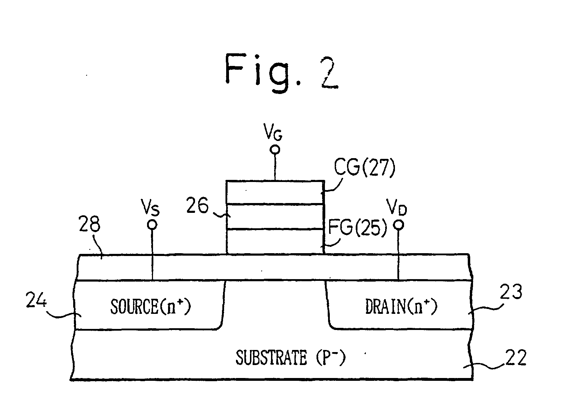

Fig. 2 of the accompanying drawings shows diagrammatically a structure of a cell used in a flash memory.

In this figure, indicated at V_{G} is a gate terminal, at V_{D} a drain terminal, at V_{S} a source terminal, at 27 a control gate CG connected to the gate terminal V_{G}, and at 25 a floating gate FG which is controlled by the potential of the control gate CG.

Further, indicated at 22 is a semiconductor substrate, e.g., a semiconductor substrate having P-type conductivity. On the semiconductor substrate 22 are mounted well portions 23, 24 made of semiconductor having N-type conductivity. The well portion 23 forms a drain while the well portion 24 forms a source. Indicated at 26, 28 are insulating films.

When data is read from the cell, 0V is applied to the source terminal V_{S}, a read voltage (normal supply voltage V_{CC}) of 5V is applied to the gate terminal V_{G}, and a voltage of about 1V is applied to the drain terminal V_{D}. Then, it is discriminated whether the read data is "1" or "0" depending upon whether a current flows through the cell. On the other hand, when data is written in the cell, 0V is applied to the source terminal V_{S}, a write/erase voltage V_{PP} of about 12V is applied to the gate terminal V_{G}, and a write drain voltage V_{W} (lower than V_{PP}) is applied to the drain terminal V_{D}. Thereby, electrons are injected into the floating gate FG from a drain region (writing operation). Further, when the data is erased, the drain terminal V_{D} is brought into an open state, and 0V and the write/erase voltage V_{PP} are applied to the gate terminal V_{G} and the source terminal V_{S} respectively. Thereby, the electrons are taken from the floating gate FG to a source region (erasing operation).

When the data is written, it is required to check whether the data is written sufficiently in the memory cell (write verification). Likewise, when the data is erased it is required to check whether the data is erased sufficiently from the memory cell (erase verification).

The write verification and erase verification are carried out so as to confirm whether the degree of writing and the degree of erasing have a sufficient margin for the read voltage, i.e., a variation range of the normal supply voltage V_{CC} (5V ± 0.5V). Generally, these verifications are carried out to confirm that an operation margin of about 0.5V to 1.0V is available for a voltage range of V_{CC}. In this case, the verify voltage including the operation margin is 6V to 6.5V in the write verification, and 3.5V to 4V in the erase verification.

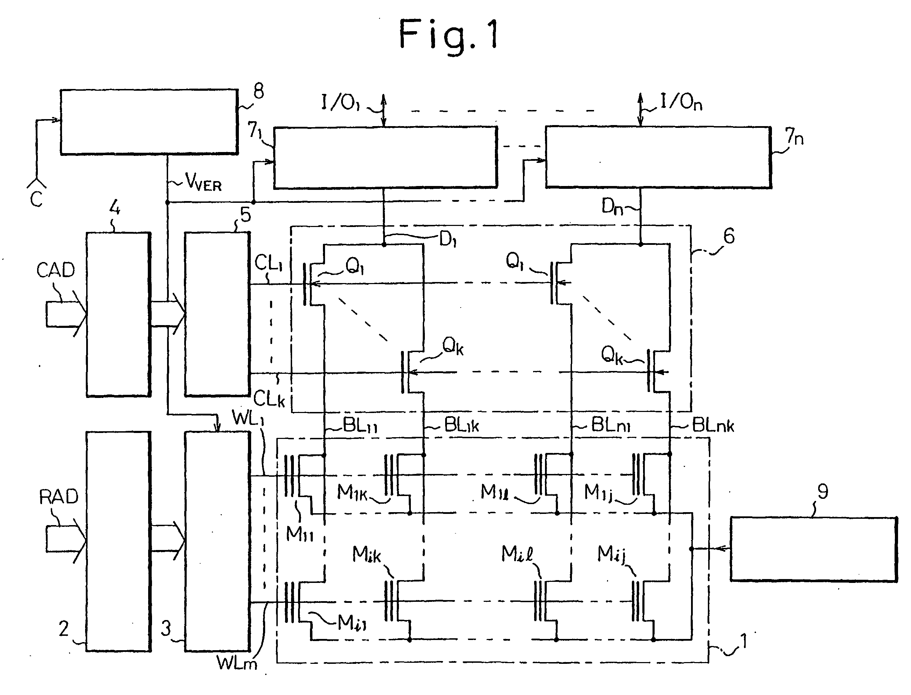

It is expected that the write verification and the erase verification can be accomplished easily if the verify voltage including the operation margin to be secured is applied to word lines (for example, word lines WL₁ to WLₘ of the flash memory shown in Fig. 1), so that the sensitivity of the S/A circuit is the same regardless of whether the voltage V_{CC} or the verify voltage is applied as the supply voltage of the S/A circuit.

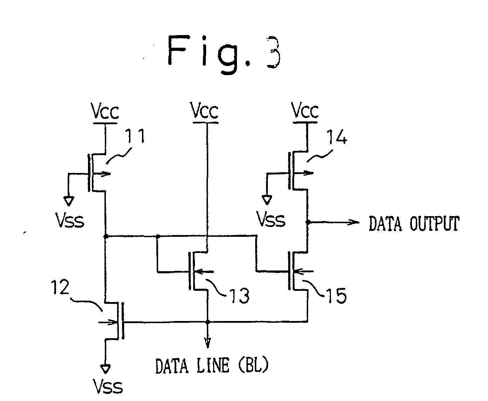

Fig. 3 of the accompanying drawings shows a construction of a general S/A circuit used in the nonvolatile semiconductor memory such as an EPROM.

In this figure, indicated at V_{CC} is a line of a supply voltage 5V, and at V_{SS} a line of a supply voltage 0V. Between the power supply lines V_{CC} and V_{SS} are connected a p-channel transistor 11 and an n-channel transistor 12 in series. A gate of the transistor 11 is connected to power supply line V_{SS}, while a gate of the transistor 12 is connected to a data line (i.e., a bit line). Between the power supply line V_{CC} and the data line is connected an n-channel transistor 13 whose gate is connected to drains of the respective transistors 11, 12. Likewise, between the power supply line V_{CC} and the data line are connected a p-channel transistor 14 and an n-channel transistor 15 in series. A gate of the transistor 14 is connected to the power supply line V_{SS}, while a gate of the transistor 15 is connected to the drains of the respective transistors 11, 12. An output (data output) of the S/A circuit is taken from drains of the respective transistors 14, 15.

In this construction, when the data read from the memory cell is "1", i.e., when the level of the data line is "H", the transistor 12 is turned on and thereby a drain potential thereof is reduced to "L" level. Accordingly, the transistor 15 is cut off. Thus, the voltage of "H" level is output from the power supply line V_{CC} through the transistor 14 (data output). In other words, the data having the same level as the read data is sensed. Conversely, when the data read from the memory cell is "0", the transistor 12 is cut off and the voltage of "H" level is fed from the power supply line V_{CC} through the transistor 11 to the gate of the transistor 15 to turn the transistor 15 on. Thereupon, the level of a data output line is reduced to "L" (the data of "L" level is the same as the read data).

In this way, the transistor 15 is provided with a function of transmitting the level of the bit line to the data output line (bit line level adjustment), and the transistor 14 is provided with a function of discriminating the data of the memory cell according to the state (on/off) of the transistor 15.

In recent years, a high speed operation has been aimed at. However, there is a limit in carrying out the data writing, data reading, and erasing operations at a high speed in the conventional nonvolatile semiconductor memory in terms of its circuit construction and software, thus realization of higher operations are earnestly demanded.

US 4823031 discloses a single-ended sense amplifier having a sensing transistor and an output driver connected to the sensing transistor. A feedback transistor is additionally provided which connects the input of the output driver to ground in dependency from the output of the output driver. This feedback transistor is intended to improve the switching speed of the sense amplifier.

An embodiment of the present invention pertains to a nonvolatile semiconductor memory including a sense amplifier for detecting a current, and an object thereof is to provide a nonvolatile semiconductor memory capable of shortening a reading time during a reading operation when a current flows through a memory cell transistor, to thereby carry out the reading operation at high speed.

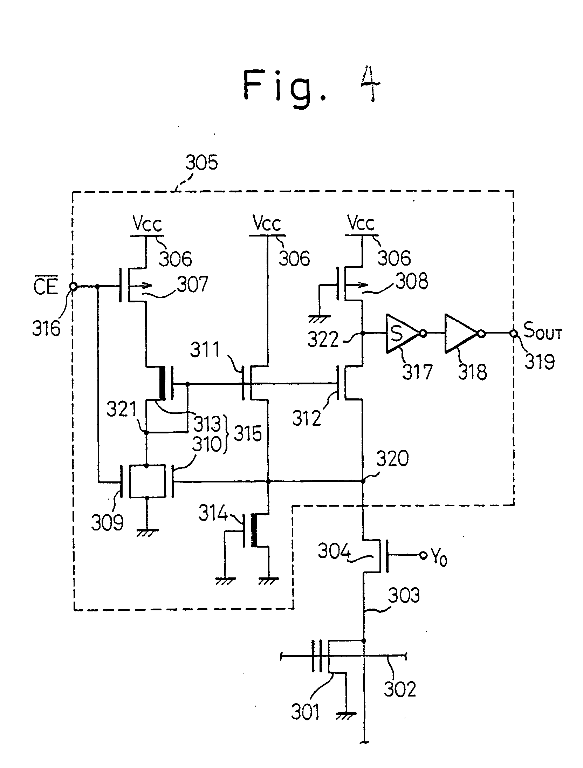

A known nonvolatile semiconductor memory device, described later in more detail with reference to Fig. 4, may be considered to comprise: a matrix of nonvolatile erasable memory cells formed at intersections of word lines and bit lines; a row decoder; a column decoder; and sense amplifiers connected operatively to the bit lines, respectively, each of the sense amplifiers comprising: load means; a current detecting first transistor connected with the load means in series between a high-potential power source and a terminal of a bit line connected to the memory cell transistors; an output portion formed at a node between the load means and the first transistor; an inverter disposed between the gate of the first transistor and the terminal of the bit line; and a third transistor having a gate connected to the output of the inverter, a source connected to the high-potential power source, and a drain connected to said bit line terminal.

A nonvolatile semiconductor memory device embodying the present invention is characterised by further comprising: a current amplifying second transistor disposed between the terminal of the bit line and a low-potential power source, the gate of the second transistor being connected to an output of the inverter.

Reference will now be made, by way of example, to the accompanying drawings, in which:
Fig. 1 is a block diagram showing parts of a flash memory to which an embodiment of the invention can be applied;
Fig. 2 is a diagram showing a cell structure for explaining an operation of the flash memory;
Fig. 3 is a circuit diagram showing the construction of an example S/A circuit of the prior art;
Fig. 4 is a circuit diagram showing parts of a sense amplifier in a prior art EPROM;
Fig. 5 is a diagram for use in explaining a principle of a sense amplifier according to an embodiment of the present invention;
Fig. 6 is a diagram for use in explaining a principle of a sense amplifier according to another embodiment of the present invention;
Fig. 7 is a circuit diagram showing parts of a first embodiment of the present invention;
Fig. 8 is a circuit diagram showing parts of a second embodiment of the present invention;
Fig. 9 is a circuit diagram showing parts of a third embodiment of the present invention;
Fig. 10 is a circuit diagram showing parts of a fourth embodiment of the present invention;
Fig. 11 is a circuit diagram showing parts of a fifth embodiment of the present invention;
Fig. 12 is a waveform chart for use in comparing an operation of the sense amplifier used in Fig. 11 and an operation of the sense amplifier shown in Fig. 4;
Fig. 13 is a circuit diagram showing parts of a sixth embodiment of the present invention;
Fig. 1 is a block diagram showing parts of a flash type memory.

In this figure, indicated at 1 is a cell array formed by arranging erasable nonvolatile memory cells Mᵢⱼ at intersections of a plurality of word lines WL₁ to WLₘ and a plurality of bit lines BL₁₁ to BL₁ₖ, ..., BLₙ₁ to BLₙₖ. In this embodiment, the cell array is divided into n blocks, in each of which (k × m) memory cells are arranged. Indicated at 2 is a row address buffer for buffering a row address RAD of an address signal fed externally thereto, at 3 a row decoder for decoding the row address and selecting any one of the word lines WL₁ to WLₘ, at 4 a column address buffer for buffering a column address CAD of the address signal, and at 5 a column decoder for decoding the column address and selecting any one of column lines CL₁ to CLₖ corresponding to the bit lines BLi₁ to BLiₖ for each of the aforementioned blocks. Indicated at 6 is a column gate circuit including transfer gate transistors Q₁ to Qₖ corresponding to the bit lines BLᵢₗ to BLᵢₖ for each of the aforementioned blocks. The respective transistors Q₁ to Qₖ are turned on when the corresponding column lines CL₁ to CLₖ are selected, to thereby connect the selected bit line BLᵢⱼ to a data line Dᵢ.

Indicated at 7₁ to 7ₙ are respectively writing circuits and S/A circuits for applying amplification to a write data and sense amplification to a read data between corresponding internal data lines D₁ to Dₙ and external input/output data lines I/O₁ to I/Oₙ. Indicated at 8 is a verify source voltage generating circuit for generating a verify voltage V_{VER} in accordance with a control signal C fed externally thereto. The generated verify source voltage V_{VER} is supplied to the selected word lines WL₁ to WLₘ through the row decoder 3 as described later, and to the S/A circuit corresponding to the selected word line. Indicated at 9 is a source voltage supply circuit for supplying a source voltage in common to the respective sources of the nonvolatile memory cells Mᵢⱼ.

An embodiment of the present invention will now be described.

In the aforementioned nonvolatile semiconductor memories, the greatest concern is: how to read various information written in the memory cell transistors at a high speed and with accuracy. In view of this, attention has always been directed to a structure of the sense amplifier itself.

Fig. 4 shows a basic portion of the structure of a sense amplifier used conventionally when the EPROM is, for example, used as a cell memory transistor in the nonvolatile semiconductor memory including a built-in sense amplifier of the current detecting type.

In this figure, indicated at 301 is a memory cell transistor, at 302 a word line, at 303 a bit line, at 304 an n-MOS transistor of the enhancement type for selecting the bit line 303 in accordance with a bit line selection signal Y₀, and at 305 a sense amplifier of the current detecting type.

In the sense amplifier 305, indicated at 306 is a power supply line for supplying a supply voltage V_{CC}, at 307, 308 p-MOS transistors of the enhancement type, at 309 to 312 n-MOS transistors of the enhancement type, and at 313, 314 n-MOS transistors of the depletion type.

The n-MOS transistors 310 and 313 constitute an inverter 315 of the so-called E/D (enhancement/depletion) type in which the n-MOS transistors 310, 313 are used as a drive transistor and a load transistor respectively.

Indicated at 316 is a chip enable signal input terminal to which a chip enable signal /CE is input, at 317 a Schmidt trigger inverter, at 318 a normal inverter, and at 319 a sense amplifier output terminal from which a sense amplifier output Sout is output.

Particularly, the p-MOS transistor 307 and the n-MOS transistor 309 are transistors operable to make the sense amplifier 305 inactive (to be described later)in the case where this EPROM is not selected so that power is not consumed in the sense amplifier 305.

The p-MOS transistor 308 is a load transistor for detecting whether a current flows through the selected memory cell transistor during the reading operation, and a gate thereof is grounded.

The n-MOS transistor 314 is a transistor for supplementing the current flowing through the p-MOS transistor 308 so as to facilitate the current detection in the p-MOS transistor 308 since only a small amount of current flows through the selected memory cell transistor even when the selected memory cell transistor is turned on during the reading operation.

The n-MOS transistors 311, 312 and the inverter 315 are adapted to reduce the voltage at a node 320 when it increases, and to stabilize the same at, for example, 1V.

More specifically, a circuit constant is set such that when the voltage at the node 320 is higher than 1V, the potential at an output terminal of the inverter 315, namely a node 321, decreases to thereby reduce the amount of current flowing through the n-MOS transistors 311, 312, the voltage at the node 320 is stabilized at 1V.

In this example, the circuit constant is also set such that the voltage at the node 322 becomes "H" relative to the Schmidt trigger inverter 317 when the voltage at the node 320 is IV.

The n-MOS transistor 311 also has function to speed up the charging operation to charge the bit-lines.

In the EPROM thus constructed, when the EPROM is not selected the chip enable signal /CE becomes "H"; the p-MOS transistor 307 is turned off; and the n-MOS transistor 309 is turned on.

As a result, the supply of the supply voltage V_{CC} to the inverter 315 is interrupted, and the n-MOS transistors 311 and 312 are turned off so that no power is consumed in the sense amplifier 305.

Contrary to this, when the EPROM is selected, the chip enable signal /CE becomes "L"; the p-MOS transistor 307 is turned on; and the n-MOS transistor 309 is turned off.

As a result, the supply voltage V_{CC} is supplied to the inverter 315 through the p-MOS transistor 307, and the n-MOS transistors 311 and 312 are turned on, thereby bringing the sense amplifier 305 into an active state.

In the case where no current flows through the memory cell transistor, when the n-MOS transistor 304 is turned an and the memory cell transistor 301 is selected (i.e. when the word line is "H" and the bit line selection signal Y₀ is "H"),the voltage at the node 320 increases due to the current supplied through the p-MOS transistor 308 and the n-MOS transistor 312 and the current supplied through the n-MOS transistor 311.

In this case, as described above, the voltage at the node 321 decreases to thereby reduce the amount of current flowing through the n-MOS transistors 311, 312, and the voltage at the node 320 is stabilized at 1V. As a result, the level of the node 322 becomes "H", and "H" is output to the sense amplifier output terminal 319 as the sense amplifier output Sout.

Contrary to this, in the case where current flows through the memory cell transistor 301, the voltage at the node 320 decreases, with the result that the level of the node 322 becomes "L" and "L" is output to the sense amplifier output terminal 319 as the sense amplifier output Sout.

In this EPROM, the n-MOS transistor 314 is provided to facilitate the current detection in the p-MOS transistor 308, and to supplement the current flowing through the p-MOS transistor 308 during the reading operation so as to carry out the reading operation at high speed. It is required in the commercial market to shorten a reading time further so as to carry out the reading operation at high speed in the case where the current flows through the selected memory cell transistor.

In view of the problems residing in the prior art, an embodiment of the present invention seeks to provide a nonvolatile semiconductor memory including a sense amplifier for detecting a current which is capable of shortening a reading time to carry out a reading operation at high speed in the case where the current flows through a memory cell transistor during the reading operation.

More specifically, in an embodiment of the present invention the sense amplifier used in the nonvolatile semiconductor memory is provided with a function of carrying out computational processing at a higher speed if a larger amount of current is caused to flow. However, since only a small amount of current flows through the memory cell transistor, the ability to drive the sense amplifier is suppressed.

This creates the problem that the sense amplifier cannot clearly determine whether the current flowing through the memory cell transistor is higher or lower than a reference value.

As a countermeasure to this problem, it is considered that a change in the current may be easily detected by conducting the comparison while causing a relatively large amount of current to flow without changing the ratio, rather than by comparing the small amount of currents.

In view of this, a basic concept of an embodiment of the present invention is to detect the level of the current flowing through the memory cell transistor by causing another current to flow simultaneously with the current flowing through the memory cell transistor.

More specifically, an embodiment of the present invention is directed to a nonvolatile semiconductor memory comprising a cell matrix circuit (1) having erasable nonvolatile memory cell transistors (Mᵢⱼ) arranged at intersections of a plurality of word lines (WL₁ to WLₙ) and a plurality of bit lines (BL₁ₗ to BL₁ₖ, ..., BLₙ₁ to BLₙₖ); and sense amplifying circuits (7₁ to 7ₙ) connected to the respective bit lines (BL₁ₗ to BL₁ₖ, ..., BLₙ₁ to BLₙₖ), wherein each sense amplifying circuit includes load means and a first transistor for detecting a current arranged in series between a high voltage supply and one terminal of the bit line connected to the memory cell transistor; an output portion provided at a node of the load means and the first transistor; an inverter arranged between a gate of the first transistor and a terminal of the bit line; and a second transistor for amplifying the current arranged between the terminal of the bit line and a low voltage supply, a gate of the second transistor being connected to an output portion of the inverter.

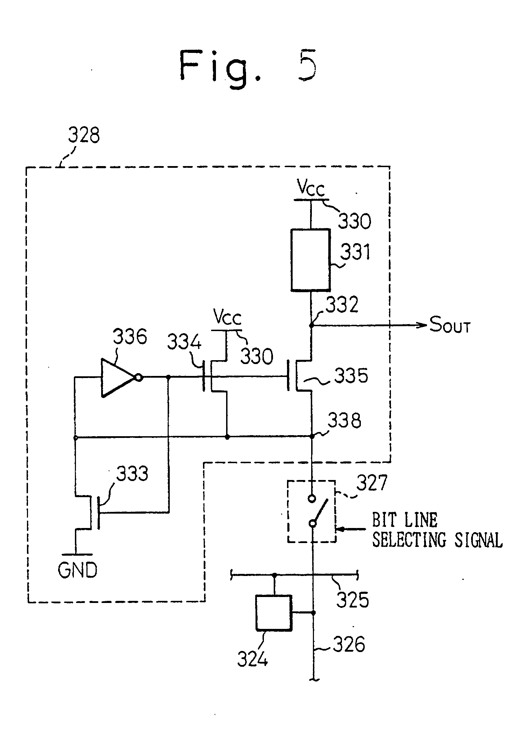

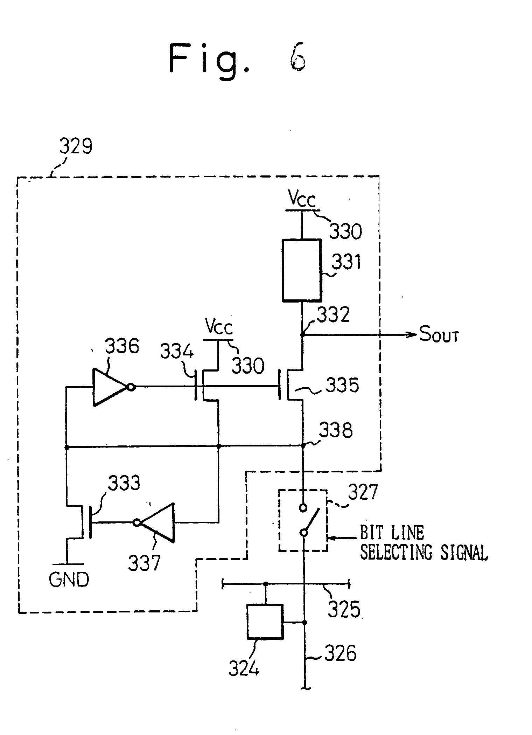

Figs. 5 and 6 show a principle of the sense amplifier in an embodiment of the present invention. In these Figures, the reference numeral 324 denotes a memory cell transistor, 325 a word line, 326 a bit line, 327 a bitline selecting switching device of which the on-off operation is controlled with a bit line select signal, and 328 (Figure 5) and 329 (Figure 6) sense amplifiers.

In the illustrations of the sense amplifiers 328 and 329, the reference numeral 330 denotes a power line over which a power-supply voltage Vcc is supplied, 331 a load intended for detection of whether or not a current flows through a selected memory cell transistor at the time of data reading, 332 a node at which sense amplifier output Sout develops, 333 to 335 n-channel MOS transistors, and 336 and 337 (Figure 6) inverters.

The n-channel MOS transistor 333 is provided to supplement the current flowing to the load 331 in order to facilitate the detection of a current at the load 331 since the current flowing through the selected memory cell transistor is turned on at the time of data reading.

The n-channel MOS transistors 334 and 335 and the inverter 336 are provided to stabilize at a predetermined level the voltage at the junction of the n-channel MOS transistor 335 and switching device 327, that is, the voltage at the node 338.

It should be noted here that the n-channel MOS transistor 334 also serves to supplement the current flowing through the n-channel MOS transistor 333 when the selected memory cell transistor is turned off and thus no current flows through the memory cell transistor.

In this embodiment, the circuit is so designed that the voltage at the gate of the n-channel MOS transistor 333 is controlled to fall when the voltage at the node 338 rises at the time of data reading and to rise when the voltage at the node 338 falls at the time of data reading.

Figs. 5 and 6 show example circuit configurations of embodiments of the present invention. Fig. 5 shows an example circuit configuration in which the inverter 336 is connected at the output terminal thereof to the gate of the n-channel MOS transistor 333, and Fig. 6 shows another example circuit configuration in which the inverter 337, different from the inverter 336 whose input terminal is connected to the node 338, is connected at the output terminal thereof to the gate of the n-channel MOS transistor 333.

An example circuit configuration of the sense amplifier used in an embodiment of the present invention will be discussed in detail below. A flash-type memory embodying the present invention comprises the sense amplifier 328 or 329 having the first n-channel MOS transistor 335 connected at the drain thereof to the power line by means of the load 331 and at the source thereof to one terminal of a bit-line selecting switching device 327 (the other terminal of which is connected to the bit line 326); the first inverter 336 connected at the input terminal thereof to the node 338, that is, the junction of the first n-channel MOS transistor 335 and the switching device 327, and at the output terminal to the gate of the first n-channel MOS transistor 335; the second n-channel MOS transistor 334 connected at the drain thereof to the power line 330, at the source thereof to the node 338, that is, the junction of the first n-channel MOS transistor 335 and the switching device 327, and at the gate thereof to the output terminal of the first inverter 336; the third n-channel MOS transistor 333 connected at the drain thereof to the node 338, that is, the junction of the first n-channel MOS transistor 335 and the switching device 327, and at the source thereof to the ground potential and so controlled that its gate voltage falls when the voltage at the node 338, that is, the junction of the first n-channel MOS transistor 335 and the switching device 327 rises at the time of data reading while it rises when the voltage at the node 338 falls, whereby a sense amplifier output Sout develops at the node 332, that is, the junction of the load 331 and the first n-channel MOS transistor 335.

In this embodiment, the n-channel MOS transistor 333 is so controlled that when the voltage at the node 338 falls, namely, when a current flows through a selected memory cell transistor at the time of data reading, the voltage at the gate of the n-channel MOS transistor 333 rises. Therefore, the current flowing through the load 331 can be increased to shorten the time taken for the signal "L" to develop at the sense amplifier output Sout, namely, the time taken for data reading when the current flows through the selected memory cell transistor, thereby permitting a higher data reading speed.

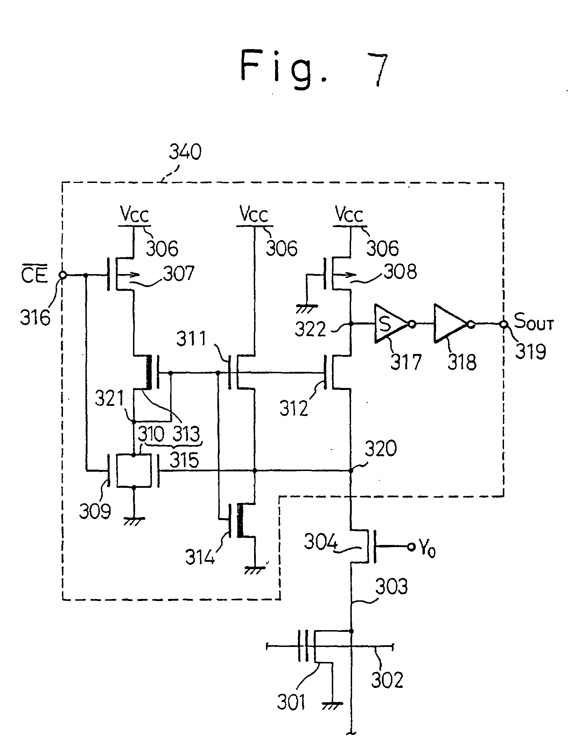

Embodiments of the present invention will now be described with reference to Figs. 7 to 13.

Fig. 7 is a circuit diagram showing parts of a first embodiment of the present invention. In the Figure, the reference numeral 340 denotes a sense amplifier in which an n-channel MOS. transistor 314 is connected at the gate thereof to the output terminal of an inverter 315. The remaining configuration is similar to that of the conventional EPROM shown in Fig. 4.

Also in this sense amplifier, however, when the n-channel MOS transistor 304 is turned off with the bit line select signal Yo taking the L level, the voltage at the node 320 becomes stable at 1V. The circuit constant is so set that in this case the voltage at the node 322 takes the H level with respect to the Schmidt-trigger inverter 317.

In this first embodiment, when the EPROM is not selected, the chip enable signal/CE takes the H level so that the p-channel MOS transistor 307 is turned off while the n-channel MOS transistor 309 is turned on.

This results in the supply of the power-supply voltage Vcc to the inverter 315 being interrupted, the n-channel MOS transistor 311 being turned off and the n-channel MOS transistor 312 also being turned off so that no power will be consumed in the sense amplifier 340.

On the contrary, in this embodiment, when the EPROM is selected, the chip enable signal/CE takes the L level so that the p-channel MOS transistor 307 is turned on while the n-channel MOS transistor 309 is turned off.

Thus the power-supply voltage Vcc is supplied again to the inverter 315 through the p-channel MOS transistor 307, and the n-channel MOS transistors 311 and 312 are turned on so that the sense amplifier is activated.

Assume here that the word line 302 takes the H level and the n-channel MOS transistor 304 is turned on (i.e. the bit line select signal Yo takes the H level)so that the memory cell transistor 301 is selected. When no current flows through the memory cell transistor 301, the voltage at the node 320 rises due to the current supplied through the p-channel MOS transistor 308 and the n-channel MOS transistor 312 and the current supplied through the n-channel MOS transistor 311.

The voltage at the node 321 then falls, the current flowing through the n-channel MOS transistors 311 and 312 decreases, the voltage at the node 320 becomes stable at 1V, the node 322 takes the H level, and a sense amplifier output Sout at the H level develops at the sense amplifier output terminal 319.

On the contrary, when a current flows through the memory cell transistor 301, the voltage at the node 320 falls, so that the voltage at the node 322 takes the L level and a sense amplifier output Sout at the L level develops at the sense amplifier output terminal 319.

In this first embodiment, when the voltage at the node 320 falls, the voltage at the node 321 rises, the gate voltage of the n-channel MOS transistor 314 rises and the current flowing through the n-channel MOS transistor 314 increases.

Hence, in this first embodiment, if a current flows through a selected memory cell transistor at the time of data reading, the time required for the node 322 to take the L level can be shortened and the data reading can be effected at a high speed compared to the case that the n-channel MOS transistor 314 is connected at the gate thereof to the ground potential.

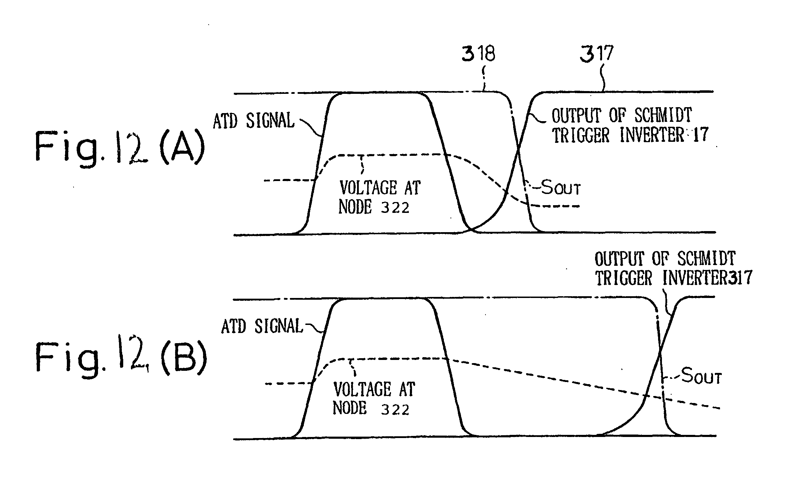

Namely, as seen from the comparison waveforms in Fig. 12, even if the voltage at the node 322 is raised to some extent by using an address transition detection (ATD) circuit in the aforementioned embodiment of the present invention, the control circuit in this embodiment comprising the second transistor and inverter permits the time required for the node 322 to take the L level to be shortened as indicated with the waveform (A) and considerably shortens the time taken for data reading compared to the corresponding waveform (B) in the conventional circuit configuration.

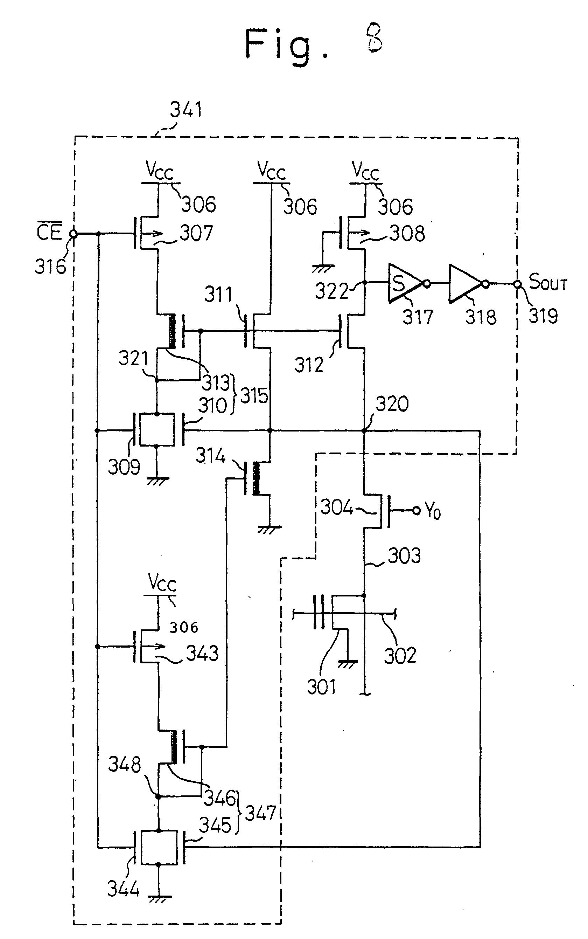

Fig. 8 is a circuit diagram showing partsof a second embodiment of the present invention. In the Figure, the reference numeral 341 denotes a sense amplifier comprising a power line 306 over which the power-supply voltage Vcc is supplied, an enhancement-type p-channel MOS transistor 343, enhancement-type n-channel MOS transistors 344 and 345, and a depletion-type n-channel MOS transistor 346.

In this embodiment, an E/D-type inverter 347 is made up of then-channel MOS transistor 345 ( drive transistor)and the n-channel MOS transistor 346 ( load transistor).

More particularly, this second embodiment has a circuit configuration that includes the p-channel MOS transistor 343, n-channel MOS transistor 344 and the inverter 347. The input terminal of the inverter 347 is connected to the node 320 and the n-channel MOS transistor 314 is connected at the gate thereof to the node 348. In other respects, the second embodiment is similar to the first embodiment shown in Fig. 7.

In the second embodiment, when the word line 302, for example, takes the H level and the bit line select signal Yo takes the H level, the n-channel MOS transistor 304 is turned on so that the memory cell transistor 301 is selected. If no current flows through the memory cell transistor 301, the voltage at the node 320 rises due to the current supplied through the p-channel MOS transistor 308 and n-channel MOS transistor 312 and the current supplied through the n-channel MOS transistor 311.

The voltage at the node 321 then falls, the current flowing through the n-channel MOS transistors 311 and 312 decreases, the voltage at the node 320 becomes stable at 1V, the node 322 takes the H level and a sense amplifier output Sout at the H level develops at the sense amplifier output terminal 319.

On the contrary in this second embodiment, when a current flows through the memory cell transistor 301, the voltage at the node 320 falls with the result that the voltage at the node 322 takes the L level and a sense amplifier output Sout at the L level develops at the sense amplifier output terminal 319.

In this second embodiment, when the voltage at the node 320 falls, the voltage at the node 348, which is the output terminal of the inverter 347, rises and the gate voltage of the n-channel MOS transistor 314 also rises, so that a current flowing through the n-channel MOS transistor 314 increases.

Hence, also in this second embodiment, if a current flows through a selected memory cell transistor at the time of data reading, the time required for the node 322 to take the L level can be shortened and the data reading can be done at a high speed compared to the case that the n-channel MOS transistor 314 is connected at the gate thereof to the ground potential.

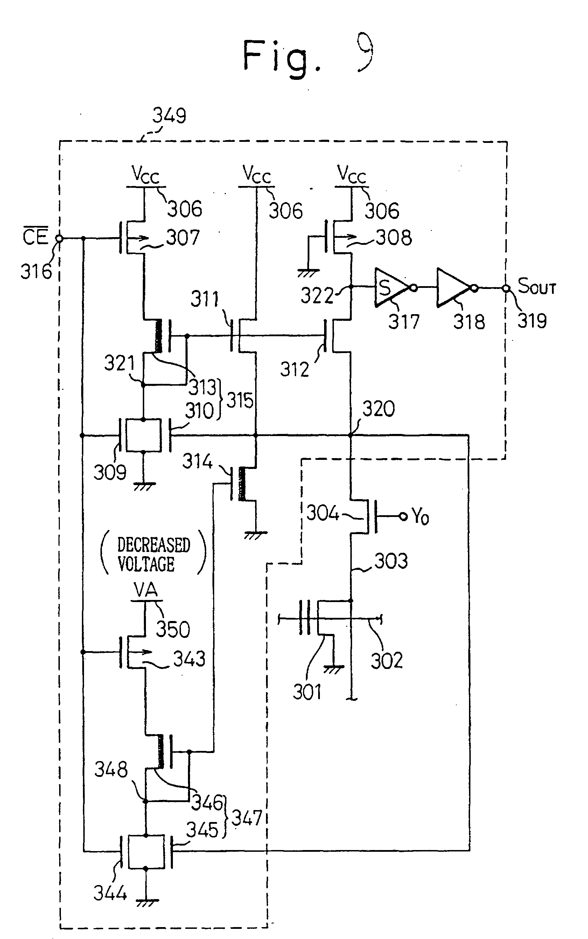

Fig. 9 is a circuit diagram showing parts of a third embodiment of the present invention. In the Figure, the reference numeral 349 denotes a sense amplifier having a low voltage line 350, which supplies a low voltage VA produced by dropping the power-supply voltage Vcc.

More particularly, the circuit of this third embodiment is so configured that the low voltage VA is supplied through the p-channel MOS transistor 343 to the inverter 347, which will be operated with the low voltage VA. In other respects, the third embodiment is similar to the second embodiment shown in Fig. 8.

The third embodiment has a similar effect to that of the second embodiment. Furthermore, the rise of the voltage at the node 348 when the voltage at the node 320 falls is more limited than in the second embodiment. This has the effect of limiting the rise of the gate voltage of the n-channel MOS transistor 314, thereby preventing a fault from occurring as a result of the current flowing through the n-channel MOS transistor 314 becoming too large.

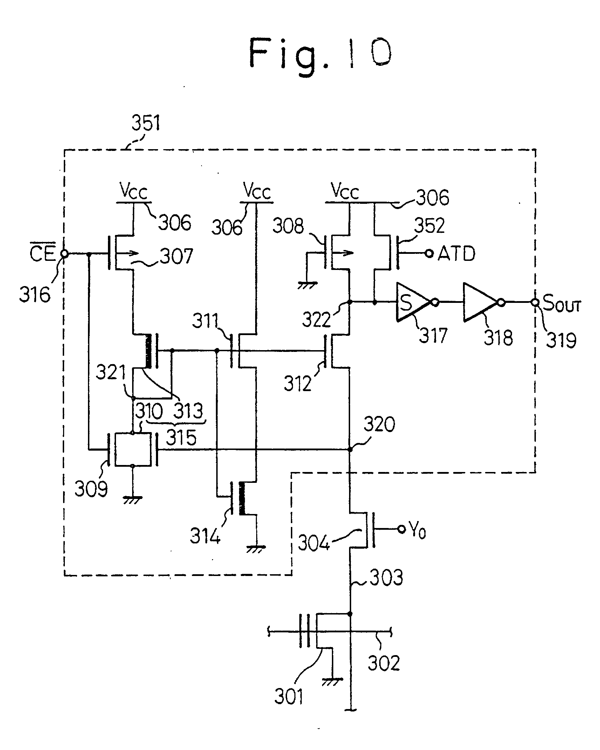

Fig. 10 is a circuit diagram showing parts of a fourth embodiment of the present invention. In the Figure, the reference numeral 351 denotes a sense amplifier comprising an n-channel MOS transistor 352 connected at the drain thereof to the power line 306, at the source thereof to the node 322 and supplied at the gate thereof with an ATD signal. In other respects, this fourth embodiment is similar to the first embodiment shown in Fig. 7.

In this fourth embodiment, if the nodes 320 and 322 are precharged based on the ATD signal so that no current flows through a selected memory cell transistor at the time of data reading, the status with the H level can be read at a higher speed.

Also in this fourth embodiment, the n-channel MOS transistor 314 is connected at the gate thereof to the node 321 as in the first embodiment, so that when the voltage at the node 320 falls at the time of data reading, the gate voltage of the n-channel MOS transistor 314 rises and the current flowing through the n-channel MOS transistor 314 increases.

Hence, in the fourth embodiment, when a current flows through a selected memory cell transistor at the time of data reading in the case that the nodes 320 and 322 are precharged based on the ATD signal, the time required for the node 322 to take the L level can be shortened and the data reading can be done at a high speed compared to the case when the n-channel MOS transistor 314 is connected at the gate thereof to the ground potential.

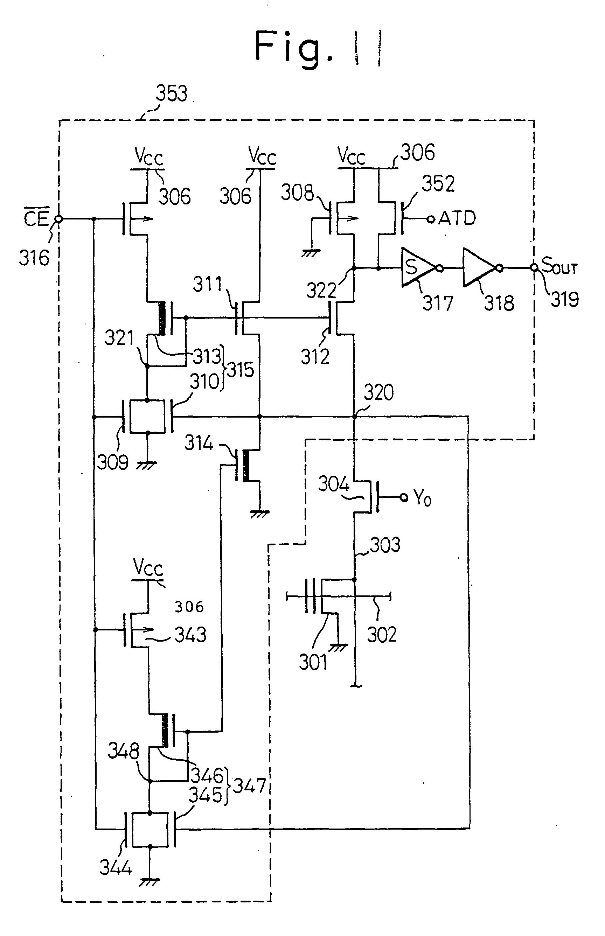

Fig. 11 is a circuit diagram showing parts of a fifth embodiment of the present invention. In the Figure, the reference numeral 353 denotes a sense amplifier comprising an MOS transistor 352 connected at the drain thereof to the power line 306, at the source thereof to the node 322 and supplied at the gate thereof with an ATD signal. In other respects, this fifth embodiment is similar to the second embodiment shown in Fig. 8.

Also in this fifth embodiment, if the nodes 320 and 322 are precharged based on the ATD signal so that no current flows through a selected memory cell transistor at the time of data reading, the status with the H level can be read at a higher speed.

Also in this fifth embodiment, the n-channel MOS transistor 314 is connected at the gate thereof to the node 348 as in the second embodiment, so that when the voltage at the node 320 falls at the time of data reading, the gate voltage of the n-channel MOS transistor 314 rises and the current flowing through the n-channel MOS transistor 314 increases.

Hence, in the fifth embodiment, when a current flows through a selected memory cell transistor at the time of data reading in the case that the nodes 320 and 322 are precharged based on the ATD signal, the time required for the node 322 to take the L level can be shortened and the data reading can be done at a high speed compared to the case when the n-channel MOS transistor 314 is connected at the gate thereof to the ground potential.

Fig. 12 is a waveform diagram showing the operation of the sense amplifier 353 as shown in Fig. 11 used in the fifth embodiment in comparison with the operation of the conventional sense amplifier 305 shown in Fig. 4. Fig. 12 (A) is a waveform diagram showing the operation of the sense amplifier 353 as shown in Fig. 11, incorporated in the fifth embodiment, and Fig. 12 (B) is a waveform diagram showing the operation of the sense amplifier 305 shown in Fig. 4.

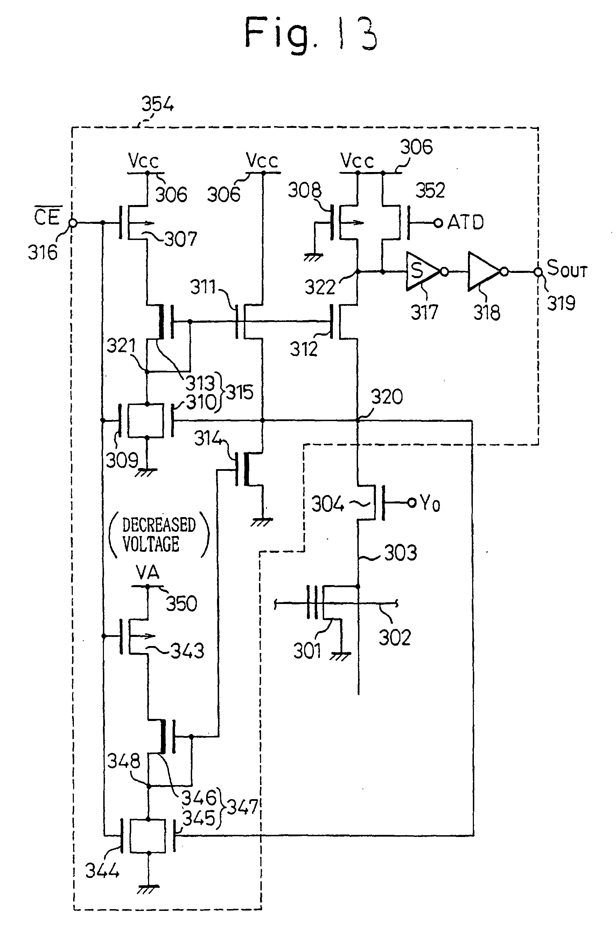

Fig. 13 is a circuit diagram showing parts of a sixth embodiment of the present invention. In the Figure, the reference numeral 354 denotes a sense amplifier comprising an n-channel MOS transistor 352 connected at the drain thereof to the power line 306, at the source thereof to the node 322 and supplied at the gate thereof with an ATD signal. In other respects, the sixth embodiment is similar to the third embodiment shown in Fig. 9.

In this sixth embodiment as shown in Fig. 13, if the nodes 320 and 322 are precharged based on the ATD signal so that no current flows through a selected memory cell transistor at the time of data reading, the status with the H level can be read at a higher speed.

Also in this sixth embodiment, the n-channel MOS transistor 314 is connected at the gate thereof to the node 348 as in the third embodiment, so that when the voltage at the node 320 falls at the time of data reading, the gate voltage of the n-channel MOS transistor 314 rises and the current flowing through the n-channel MOS transistor 314 increases.

Hence, in the sixth embodiment, when a current flows through a selected memory cell transistor at the time of data reading in the case that the nodes 320 and 322 are precharged based on the ATD signal, the time required for the node 322 to take the L level can be shortened and the data reading can be done at a high speed as compared to the case when the n-channel MOS transistor 314 is connected at the gate thereof to the ground potential.

Also in this sixth embodiment, the inverter 347 is supplied with a low voltage VA. Thus, when the voltage at the node 320 falls, the rise of the gate voltage of the n-channel MOS transistor 314 is limited more than in the fifth embodiment in decreasing the current through the n-channel MOS transistor 314, thereby preventing a fault from occuring as a result of the current flowing through the n-channel MOS transistor 314 becoming too large.

As described in the foregoing, in an embodiment of the present invention when a current flows through a selected memory cell transistor at the time of data reading, the n-channel MOS frensistor that supplements the current flowing through the load has a rise in its gate voltage. Thus, when a current flows through a selected memory cell transistor at the time of data reading, the current through the load is increased so that the time required for data reading when the current flows through the selected memory cell transistor can be shortened and the data reading can be effected at a higher speed.

## Claims

1. A nonvolatile semiconductor memory having a matrix (1) of nonvolatile erasable memory cells (Mij; 324) formed at intersections of word lines (WL1 to WLm; 325) and bit lines (BL11 to BL1k, ..., BLn1 to BLnk; 326), a row decoder (3), a column decoder (5), and sense amplifiers (71 to 7n; 328) connected operatively to the bit lines (BL11 to BL1k, ..., BLn1 to BLnk; 326), respectively, each of the sense amplifiers comprising:
load means (331);
a current detecting first transistor (335) connected with the load means (331) in series between a high-potential power source (Vcc) and a terminal (338) of a bit line (326) connected to the memory cell transistors (324);
an output portion formed at a node (332) between the load means (331) and the first transistor (335);
an inverter (336) disposed between the gate of the first transistor (335) and the terminal (338) of the bit line (326); and
a third transistor (334) having a gate connected to the output of the inverter (336), a source connected to the high-potential power source (Vcc), and a drain connected to said bit line terminal (338);
**characterized in that** said nonvolatile semiconductor memory further comprises:
a current amplifying second transistor (333) disposed between the terminal (338) of the bit line (326) and a low-potential power source (GND), the gate of the second transistor (333) being connected to an output of the inverter (336).

2. The nonvolatile semiconductor memory according to claim 1, wherein the gate of the second transistor (333) is biased depending on the quantity of a current flowing to the memory cell transistors (324).

3. The nonvolatile semiconductor memory according to any preceding claim, wherein the second transistor (333) is a depletion NMOS transistor.

4. The nonvolatile semiconductor memory according to any preceding claim, further comprising:
a second inverter (337) connected to the gate of the second transistor (333), an input of the second inverter (337) being connected to a node between the third transistor (334) and the terminal (338) of the bit line (326).

5. The nonvolatile semiconductor memory according to claim 4, wherein the second inverter (337) is driven with a voltage formed by dropping the high-potential power source (Vcc).

## Patentansprüche

1. Nicht-flüchtiger Halbleiterspeicher mit einer Matrix (1) aus nicht-flüchtigen löschbaren Speicherzellen (Mij; 324), die an Schnittpunkten von Wortleitungen (WL1 bis WLm; 325) und Bitleitungen (BL11 bis BL1k, ..., BLn1 bis BLnk; 326) gebildet sind, einem Reihendecoder (3), einem Spaltendecoder (5), und Leseverstärkern (71 bis 7n; 328), die jeweils operativ mit den Bitleitungen (BL11 bis BL1k, ..., BLn1 bis BLnk; 326) verbunden sind, wobei jeder der Leseverstärker umfaßt:
eine Lasteinrichtung (331);
einen ersten Stromdetektiertransistor (335), der mit der Lasteinrichtung (331) zwischen einer Energiequelle (Vcc) mit hohem Potential und einem Anschluß (338) einer Bitleitung (326), die mit den Speicherzellentransistoren (324) verbunden ist, in Serie geschaltet ist;
einen Ausgangsteil, der an einem Knoten (332) zwischen der Lasteinrichtung (331) und dem ersten Transistor (335) gebildet ist;
einen Inverter (336), der zwischen dem Gate des ersten Transistors (335) und dem Anschluß (338) der Bitleitung (326) positioniert ist; und
einen dritten Transistor (334) mit einem Gate, das mit dem Ausgang des Inverters (336) verbunden ist, einer Source, die mit der Energiequelle (Vcc) mit hohem Potential verbunden ist, und einem Drain, der mit dem Bitleitungsanschluß (338) verbunden ist;
**dadurch gekennzeichnet, daß** der nicht-flüchtige Halbleiterspeicher ferner umfaßt:
einen zweiten Stromverstärkertransistor (333), der zwischen dem Anschluß (338) und der Bitleitung (326) und einer Energiequelle (GND) mit niedrigem Potential positioniert ist, wobei das Gate des zweiten Transistors (333) mit einem Ausgang des Inverters (336) verbunden ist.

2. Nicht-flüchtiger Halbleiterspeicher nach Anspruch 1, bei welchem das Gate des zweiten Transistors (333) in Abhängigkeit von der Menge eines zu den Speicherzellentransistoren (324) fließenden Stroms vorgespannt ist.

3. Nicht-flüchtiger Halbleiterspeicher nach einem der vorhergehenden Ansprüche, bei welchem der zweite Transistor (333) ein Verarmungs-NMOS-Transistor ist.

4. Nicht-flüchtiger Halbleiterspeicher nach einem der vorhergehenden Ansprüche, welcher ferner umfaßt:
einen zweiten Inverter (337), der mit dem Gate des zweiten Transistors (333) verbunden ist, wobei ein Eingang des zweiten Inverters (337) mit einem Knoten zwischen dem dritten Transistor (334) und dem Anschluß (338) der Bitleitung (326) verbunden ist.

5. Nicht-flüchtiger Halbleiterspeicher nach Anspruch 4, bei welchem der zweite Inverter (337) mit einer Spannung getrieben wird, die durch das Abfallen der Energiequelle (Vcc) mit hohem Potential gebildet wird.

## Revendications

1. Une mémoire à semiconducteur non volatile ayant une matrice (1) de cellules de mémoire de type effaçable non volatile (Mij; 324) formées à des intersections de conducteurs de mot (WL1 à WLm) et de conducteurs de bits (BL11 à BL1k, ..., BLn1 à BLnk; 326), un décodeur de ligne (3), un décodeur de colonne (5) et des amplificateurs de lecture (71 à 7n; 328) connectés fonctionnellement aux conducteurs de bit (BL11 à BL11(, ..., BLn1 à BLnk; 326), respectivement, chacun des amplificateurs de lecture comprenant :
des moyens de charge (331);
un premier transistor de détection de courant (335) connecté aux moyens de charge (331) en série entre une source d'alimentation de potentiel haut (Vcc) et une borne (338) d'un conducteur de bit (326) connecté aux transistors de cellule de mémoire (324);
une partie de sortie formée à un noeud (332) entre les moyens de charge (331) et le premier transistor (335);
un inverseur (336) placé entre la grille du premier transistor (335) et la borne (338) du conducteur de bit (326); et
un troisième transistor (334) ayant une grille connectée à la sortie de l'inverseur (336), une source connectée à la source d'alimentation de potentiel haut (Vcc), et un drain connecté à la borne de conducteur de bit (338);
**caractérisée en ce que** cette mémoire à semiconducteur non volatile comprend en outre :
un second transistor d'amplification de courant (333) placé entre la borne (338) du conducteur de bit (326) et une source d'alimentation de potentiel bas (GND), la grille du second transistor (333) étant connectée à une sortie de l'inverseur (336).

2. La mémoire à semiconducteur non volatile selon la revendication 1, dans laquelle la grille du second transistor (333) est polarisée sous la dépendance du niveau d'un courant circulant vers les transistors de cellule de mémoire (324).

3. La mémoire à semiconducteur non volatile selon l'une quelconque des revendications précédentes, dans laquelle le second transistor (333) est un transistor NMOS à déplétion.

4. La mémoire à semiconducteur non volatile selon l'une quelconque des revendications précédentes, comprenant en outre :
un second inverseur (337) connecté à la grille du second transistor (333), une entrée du second inverseur (337) étant connectée à un noeud entre le troisième transistor (334) et la borne (338) du conducteur de bit (326).

5. La mémoire à semiconducteur non volatile selon la revendication 4, dans laquelle le second inverseur (337) est attaqué par une tension formée en faisant subir une chute à la tension de source d'alimentation de potentiel haut (Vcc).
